# EUROPÄISCHE PATENTSCHRIFT

(11) **EP 0 706 201 B1**
(45) Veröffentlichungstag und Bekanntmachung des Hinweises auf die Patenterteilung: **04.12.2002**
(21) Anmeldenummer: 95112859.4
(22) Anmeldetag: 16.08.1995
(51) Int. Cl.: H01J 61/40, H01J 61/82, H01J 61/86

(54) **Quecksilberdampf-Kurzbogenlampe**
Mercury vapour lamp with short arc
Lampe à arc court à vapeur de mercure

(30) Priorität: 12.09.1994 DE 4432315
(43) Veröffentlichungstag der Anmeldung: 10.04.1996
(73) Patentinhaber: Patent-Treuhand-Gesellschaft für elektrische Glühlampen mbH, 81543 München (DE)
(72) Erfinder: Dierks, Jörn, D-16352 Schönwalde (DE); Maier, Jürgen, Dr., D-13503 Berlin (DE)

(56) Entgegenhaltungen:
- EP-A- 0 598 987
- DE-C- 3 744 368
- FR-A- 1 350 354
- US-A- 4 732 842
- US-A- 5 017 839
- US-A- 5 350 972
- PATENT ABSTRACTS OF JAPAN vol. 018, no. 322 (C-1214), 20.Juni 1994 & JP 06 072738 A (TOSHIBA GLASS CO LTD), 15.März 1994,
- CHEMICAL ABSTRACTS, vol. 83, no. 8, 25.August 1975 Columbus, Ohio, US; abstract no. 68308, KLIMASHINA, E. V. ET AL: "Effect of small additions of some elements on spectral characteristics of quartz glass" XP002055904 & FIZ. KHIM. STEKLA (1975), 1(2), 162-5 CODEN: FKSTD5, 1975,

## Beschreibung

Die Erfindung betrifft eine Quecksilberdampf-Kurzbogenlampe gemäß dem Oberbegriff des Anspruchs 1.

Quecksilberdampf-Kurzbogenlampen sind etwa seit der Mitte der 30er Jahre als Projektionslichtquellen hoher Leuchtdichte und hoher UV-Strahldichte bekannt (Z. Tech. Phys. 11 (1936) 377).

Sie werden deshalb seit vielen Jahren auch in der Mikrophotolithographie für die Belichtung von Photolacken, so z.B. auch bei der Herstellung integrierter Schaltkreise, eingesetzt.

Die Weiterentwicklung der Mikrophotolithographie hat in letzter Zeit große Fortschritte gemacht. Im Mittelpunkt des Interesses standen und stehen zum einen die Erhöhung der Speicherdichte der integrierten Schaltkreise und zum anderen die Verbesserung der Wirtschaftlichkeit der eingesetzten Fertigungsverfahren.

Da die Forderung nach immer höheren Speicherdichten bei modernen integrierten Schaltkreisen die Erzeugung immer kleinerer Strukturen erforderlich macht, und die erzielte Auflösung wesentlich durch die Wellenlänge der für die Belichtung verwendeten Strahlung gegeben ist, wird seit kurzem die Strahlung der kräftigen Quecksilberlinie bei 365 nm Wellenlänge in mit Quecksilberdampf-Kurzbogenlampen ausgerüsteten Belichtungsgeräten verwendet, da neuerdings für diese Wellenlänge geeignete Abbildungssysteme zur Verfügung stehen.

Einzelheiten zu einem Belichtungsverfahren unter Verwendung von Strahlung der Wellenlänge 365 nm aus einer Quecksilberdampf-Kurzbogenlampe sind z.B. der DE-OS 35 27 855 zu entnehmen.

Ein wichtiger Schritt zur Verbesserung der Wirtschaftlichkeit bei der Herstellung integrierter Schaltkreise ist die Verkürzung der Belichtungszeiten durch den Einsatz leistungsstärkerer Lampen mit Nennleistungen im kW-Bereich.

Die von solchen leistungsstarken Quecksilberdampf-Kurzbogenlampen im kurzwelligen UV-Bereich unterhalb der Nutzwellenlänge von 365 nm abgegebene Strahlung ist jedoch beträchtlich. Sie führt trotz aufwendiger Filterung durch UV Sperrfilter (Interferenz- und Farbfilter) im Strahlengang des Beleuchtungssystems zu einer Reihe von Problemen, da sie zum einen nicht restlos ausgefiltert werden kann und zum anderen durch die Filterung unvermeidlich auch Strahlung der Nutzwellenlänge 365 nm geschwächt wird.

So wird Strahlung unterhalb von etwa 330 nm Wellenlänge im Glas der Abbildungsoptik absorbiert und muß als Wärme durch entsprechende Kühleinrichtungen abgeführt werden, um eine unzulässige Erwärmung des Systems zu vermeiden. Strahlung unterhalb von etwa 330 nm führt außerdem schon nach relativ kurzer Zeit zu Strahlenschäden in den in der Abbildungsoptik verwendeten optischen Kitten (Photopolymerisation), Strahlung unterhalb 300 nm zu Strahlenschäden in den verwendeten Gläsern (Solarisation).

Strahlung unterhalb 280 nm Wellenlänge führt durch Wechselwirkung mit der umgebenden Atmosphäre und den in ihr vorhandenen dampfförmigen Verunreinigungen (z.B. aus Prozeßchemikalien und organischen Lösungsmitteln) zur Bildung von aggressivem und reaktivem Ozon und kondensierbaren Verbindungen und Crackprodukten, die sich auf den Oberflächen der optischen Bauteile niederschlagen und störende Beläge bilden.

Um den Aufwand für UV-Sperrfilter, Kühl- und Ablufteinrichtungen zu begrenzen sowie um kostspielige Stillegungszeiten durch Wartungs-und Reparaturarbeiten an den extrem teuren Belichtungsgeräten, die üblicherweise rund um die Uhr laufen, zu minimieren, ist es infolgedessen wünschenswert, Lampen zu verwenden, die neben der Strahlung der Nutzwellenlänge 365 nm möglichst keine störende kurzwellige UV-Strahlung abgeben.

Es ist daher Aufgabe der vorliegenden Erfindung eine Quecksilberdampf-Kurzbogenlampe gemäß dem Oberbegriff des Anspruchs 1 bereitzustellen, bei der die im Entladungsbogen erzeugte Strahlung der Nutzwellenlänge 365 nm praktisch ungeschwächt außerhalb des Entladungsgefäßes zur Verfügung steht, die unerwünschte kurzwellige UV-Strahlung mit Wellenlängen kleiner 365 nm jedoch möglichst vollständig im Entladungsgefäß zurückgehalten wird.

Diese Aufgabe wird durch die kennzeichnenden Merkmale des Anspruchs 1 gelöst. Bevorzugte Ausgestaltungen der Erfindung sind in den abhängigen Ansprüchen angegeben.

Die besondere Schwierigkeit bei der Lösung dieser Aufgabe liegt darin, daß zum einen Nutzwellenlänge 365 nm und störender kurzwelliger UV-Strahlungsbereich spektral nur wenige 10nm auseinanderliegen, die einzusetzenden optischen Mittel also einen möglichst steilen Abfall der Transmission unterhalb der Nutzwellenlänge 365 nm zu kürzeren Wellenlängen hin aufweisen müssen und zum anderen sehr hohe Anforderungen an die optische Qualität der Entladungsgefäße gestellt werden, da in den modernen Belichtungsgeräten eine extreme Gleichmäßigkeit bei der Ausleuchtung der zu belichtenden Vorlagen gefordert wird.

***So offenbart z.B. EP-A-598987 ein Verfahren zur Herstellung eines mit Ceraluminat und Titanoxid dotierten homogenen Quarzglases mit geringer UV-Transparenz. Dieses Quarzglas ist jedoch zur Lösung der anstehenden Aufgabe nicht geeignet, da auch Strahlung der Nutzwellenlänge 365 nm bei Verwendung eines Entladungsgefäßes aus einem so dotiertem Quarzglas schon deutlich geschwächt wird.***

Versuche, dieses Ziel durch Verwendung von Entladungsgefäßen aus mit den Oxiden von Vanadium eventuell in Verbindung mit Titan und Zinn dotiertem Quarzglas zu erreichen, führten nur teilweise zum Erfolg.

Zum einen ist hier der durch Vanadiumoxid bewirkte Abfall der Transmission unterhalb der Nutzwellenlänge 365 nm zu kürzeren Wellenlängen hin nicht ausreichend steil, so daß je nach Stärke der Dotierung entweder immer noch ein Teil der störenden kurzwelligen Strahlung zwischen 300 und 330 nm Wellenlänge das Entladungsgefäß verlassen kann, oder aber es wird bei ausreichender Unterdrückung der kurzwelligen UV-Strahlung in diesem Wellenlängenbereich bereits Strahlung der Nutzwellenlänge absorbiert, zum anderen sind sowohl die optischen als auch die Verarbeitungseigenschaften des Quarzglasmaterials durch die gleichzeitige Dotierung mit den Oxiden von Vanadium, Titan und Zinn deutlich verschlechtert.

So zeigen aus solchem Material gefertigte Entladungsgefäße eine erhöhte Blasigkeit und - offenbar verursacht durch eine nicht ganz homogene Verteilung der eingesetzten Dotierungsstoffe im Ausgangsmaterial - gelegentlich auch streifenförmige Schlieren, durch die die hohe Gleichmäßigkeit der Lichtstärkeverteilung, wie sie für die extrem gleichmäßige Ausleuchtung der Maskenebene bei der Herstellung von integrierten Schaltkreisen in modernen Belichtungsgeräten gefordert wird, beeinträchtigt wird.

Die Herstellung der auf der Glasdrehbank in der Knallgasflamme aus dem dotierten Ausgangsquarzglasrohr manuell mit Hilfe einer Formrolle geformten Entladungsgefäße dauert zudem etwa doppelt so lange wie bei Fertigung aus undotiertem Quarzglasrohr und erfordert außerdem einen höheren Heizenergieaufwand.

Grund für die längere Herstellzeit ist die Tatsache, dass mit Metalloxiden dotiertes Quarzglas ein im IR erhöhtes Emissionsvermögen besitzt. Damit verlässt ein in der Knallgasflamme für die Verformung bis in die Gegend von etwa 2000 °C aufgeheiztes dotiertes Quarzglasrohr infolge erhöhter Strahlungskühlung deutlich rascher den Temperaturbereich, in dem eine Verformung des Quarzglases erfolgen kann, als ein entsprechendes undotiertes Quarzglasrohr. Dies hat zu Folge, dass für die Formung eines Entladungsgefäßes aus einem mit Metalloxiden dotierten Quarzglasrohr erfahrungsgemäß etwa eine doppelt so große Zahl von Aufheizvorgängen aufgewandt werden muss wie bei Einsatz eines undotierten Quarzglasrohres.

Ein weiterer Nachteil bei der Unterdrückung der störenden kurzwelligen UV-Strahlung durch Absorption in der Wand eines Entladungsgefäßes aus mit geeigneten Metalloxiden dotiertem Quarzglas ist die Tatsache, dass es z.B. bei einer Lampe mit einer Nennleistung von 1500 W durch die absorbierte Strahlungsleistung zu einer die Kolbenfestigkeit in unzulässiger Weise einschränkenden Temperaturerhöhung von ca. 150 - 200 °C im Vergleich zu einer Lampe mit einem Entladungsgefäß aus undotiertem Quarzglas kommt. Diese Temperaturerhöhung müsste bei bereits eingeführten Lampen durch aufwendige Umentwicklung mit entsprechend vergrößertem (und damit verteuertem) Entladungsgefäß und korrespondierenden Anpassungen bei den Belichtungsgeräten kompensiert werden.

In einer ersten Ausführungsform ist deshalb das Entladungsgefäß aus undotiertem Quarzglasrohr gefertigt und auf seiner Außenseite mit einem selektiv Strahlung reflektierenden Beschichtung versehen. In weiteren Ausführungsformen sind entweder zusätzlich auf seiner Innenseite eine selektiv Strahlung absorbierende Titandioxidbeschichtung oder auf seiner Innenseite eine selektiv Strahlung absorbierende Titandioxidbeschichtung und auf seiner Außenseite zusätzlich eine selektiv Strahlung absorbierende Titandioxid/Siliziumdioxid-Mischbeschichtung aufgebracht.

Die auf der Außenseite des Entladungsgefäßes selektiv Strahlung reflektierende Beschichtung besteht bevorzugt aus einem Mehrschicht-Interferenz-Reflexionsfilter.

Die zusätzlich auf dem Mehrschicht-Interferenz-Reflexionsfilter aufgebrachte absorbierende Titandioxid/Siliziumdioxid-Mischbeschichtung kann dabei als letzte hochbrechende Schicht in das Mehrschicht-Interferenz-Reflexionsfilter integriert sein.

Die selektiv Strahlung absorbierende Titandioxidbeschichtung auf der Innenseite des Entladungsgefäßes kann aber gegebenenfalls auch durch Verwendung eines Entladungsgefäßes aus mit Titandioxid dotiertem Quarzglas ersetzt werden, die Titandioxid/Siliziumdioxid-Beschichtung auf der Außenseite des Entladungsgefäßes durch eine Dotierung des Quarzglases zusätzlich mit Zinnoxid.

Das Mehrschicht-Interferenz-Reflexionsfilter reflektiert bevorzugt Strahlung im Wellenlängenbereich 240 - 300 nm und liefert eine Filterkante (entsprechend 50 % Transmission) bei einer Wellenlänge zwischen 290 und 330 nm. Es besteht aus 8 - 16, vorzugsweise 10, Schichten von ca. 30 nm bis 50 nm Dicke, d.h. im bekannten λ/4-Schicht-Aufbau, abwechselnd ZrO₂ und SiO₂; unterhalb von 240 nm findet durch das ZrO₂ auch Absorption von Strahlung statt. Die ZrO₂-Schicht besitzt einen Brechungsindex von etwa 1,98, die SiO₂-Schicht von etwa 1,45.

Die Schichten werden nach einem an sich bekannten Tauchbeschichtungsverfahren von Fa. Schott (jetzt: Fa. OPTO CHEM) auf die Außenseite des Entladungsgefäßes der fertig eingeschmolzenen, ungesockelten Lampe aufgebracht. Der Ausdehnungskoeffizient der SiO₂-Schicht ist dabei durch Dotierung mit einem Alkalimetall an den Ausdehnungskoeffizienten der ZrO₂-Schicht so angepasst, dass es trotz der hohen Betriebstemperaturen von bis zu 900 °C auf der Außenseite des Entladungsgefäßes nicht zu Trübungen oder Ablösungen der Schichten kommt.

Ein Tauchbeschichtungsverfahren zur Herstellung von optischen Einfachund Mehrfach-Interferenzschichten aus Metalloxiden ist z.B. in der Patentschrift DE 37 44 368 beschrieben.

Strahlung unterhalb 240 nm (50 % Transmission) wird vorwiegend durch die absorbierende Titandioxidbeschichtung auf der Innenseite des Entladungsgefäßes absorbiert. Die als letzte hochbrechende Schicht aufgebrachte Titandioxid/Siliziumdioxid-Mischbeschichtung absorbiert zusätzlich vom Mehrschicht-Interferenz-Reflexionsfilter transmittierte Strahlung unterhalb von etwa 280 nm (50 % Transmission).

Eine auf der Innenseite des Entladungsgefäßes aufgebrachte Titandioxid-Beschichtung und die Technik ihres Aufbringens ist seit langem von ozonfreien Xenonkurzbogenlampen für die Kinoprojektion zur Unterdrückung der kurzwelligen Ozon erzeugenden UV-Strahlung bekannt.

Auch diese Titanoxid-Beschichtung wird in einem Tauchverfahren aufgebracht.

Zur Erzeugung der Titandioxid-Beschichtung auf der Innenseite des Entladungsgefäßes wird ein entsprechendes (undotiertes) Quarzglasrohr durch definiertes Tauchen in eine Titandioxid enthaltende Suspension beschlämmt, überflüssige Beschlämmung (auf der Außenoberfläche und an den Enden) entfernt und beim Verformen des Quarzglasrohres zum Entladungsgefäß auf dessen Innenoberfläche eine im sichtbaren und langwelligem UV-Bereich transparente, optisch einwandfreie Titandioxidbeschichtung erzeugt.

Die Erzeugung einer Titandioxid/Siliziumdioxid-Mischbeschichtung auf der Außenseite des Entladungsgefäßes erfolgt ebentalls in einem Taucnveriahren auf der fertig eingeschmolzenen, ungesockelten Lampe im Rahmen der Erzeugung des Mehrschicht-Interferenz-Reflexionsfilters. Die Schichtdicke ist vergleichbar mit der Dicke der aufgebrachten Zirkonoxid- und Siliziumdioxid-Schichten.

Die Verwendung eines solchen Filters führt vorteilhafterweise bereits zu einer merklichen Absorption von Strahlung unterhalb von 330 nm; das Mehrschicht-Interferenz-Reflexionsfilter liefert also in Kombination mit einem solchen Titandioxid/Siliziumdioxid-Mischschicht einen steileren Abfall der Transmission im Wellenlängenbereich zwischen 280 und 330 nm ohne Strahlung der Nutzwellenlänge 365 nm zu dämpfen.

Um eine hohe Strahlstärke der Nutzwellenlänge zu erhalten, enthält die Lampenfüllung vorzugsweise 0,5 bis 15 mg/cm³ Quecksilber und Xenon bei einem Kaltfülldruck zwischen 0,1 und 2,0 bar, bevorzugt unter 2 bar. Der Elektrodenabstand liegt bei solchen an Gleichspannung betriebenen Lampen bevorzugt zwischen 2 und 9 mm, die Nennleistung vorteilhaft zwischen 1 und 5 kW.

Die Erfindung wird im folgenden anhand mehrerer Ausführungsbeispiele näher erläutert.

Es zeigt
- Figur 1: eine erfindungsgemäße Quecksilberdampf-Kurzbogenlampe
- Figur 2: die spektrale Strahlstärkeverteilung im Wellenlängenbereich zwischen 250 und 400 nm einer derartigen Lampe mit einem Entladungsgefäß ohne die vom Quecksilberbogen emittierte Strahlung beeinflussende Mittel auf dem Entladungsgefäß
- Figur 3a: die spektrale Filterwirkung eines bevorzugt Strahlung zwischen 240 und 300nm reflektierenden Mehrschicht-Interferenz-Reflexionsfilters auf der Außenseite des Entladungsgefäßes
- Figur 3b: die spektrale Filterwirkung eines solchen Reflexionsfilters in Kombinatio mit einer kurzwellige UV-Strahlung unterhalb 240 nm absorbierenden Titandioxid-Beschichtung auf der Innenseite des Entladungsgefäßes
- Figur 3c: die spektrale Filterwirkung eines solchen Reflexionsfilters in Kombination mit einer UV-Strahlung unterhalb 240 nm absorbierenden Titandioxidbeschichtung auf der Innenseite des Entladungsgefäßes und einer UV-Strahlung unterhalb von 280 nm absorbierenden Titandioxid/Siliziumdioxid-Mischschicht auf diesem Reflexionsfilter
- Figur 4: die spektrale Strahlstärkeverteilung im Wellenlängenbereich zwischen 250 und 400 nm einer Quecksilberdampf-Kurzbogenlampe mit einem bevorzugt Strahlung zwischen 240 und 300 nm reflektierenden Mehrschicht-Interferenz-Reflexionsfilter auf der Außenseite des Entladungsgefäßes und einer kurzwellige UV-Strahlung unterhalb 240 nm absorbierenden Titandioxid-Beschicntung auf der Innenseite des Entladungsgefäßes
- Figur 5: die spektrale Strahlstärkeverteilung im Wellenlängenbereich zwischen 250 und 400 nm einer Quecksilberdampf-Kurzbogenlampe mit einem bevorzugt Strahlung zwischen 240 und 300 nm reflektierenden Mehrschicht-Interferenz-Reflexionsfilter auf der Außenseite des Entladungsgefäßes und einer kurzwellige UV-Strahlung unterhalb 280 nm absorbierenden Titandioxid/Siliziumdioxid-Mischschicht auf diesem Reflexionsfilter in Kombination mit einer UV-Strahlung unterhalb von 240 nm absorbierenden Titandioxidbeschichtung auf der Innenseite des Entladungsgefäßes.

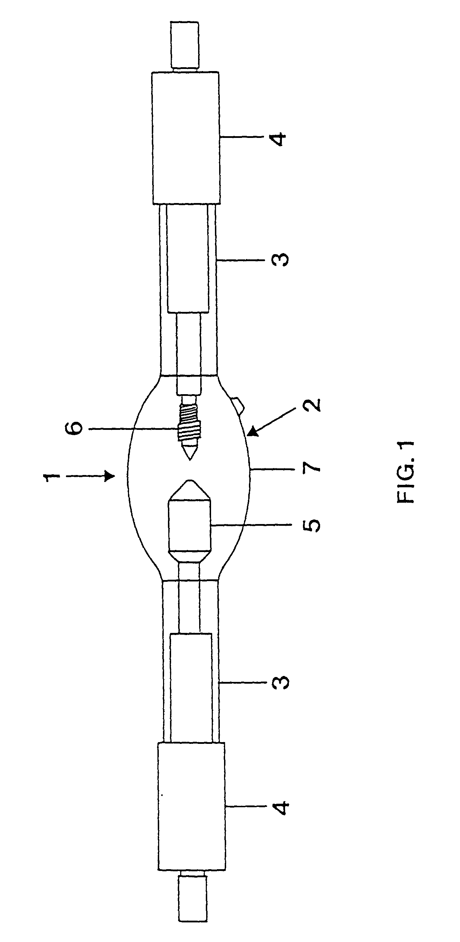

In Figur 1 ist schematisch eine Quecksilberdampf-Kurzbogenlampe 1 dargestellt. Sie besteht aus einem Entladungsgefäß 2 mit zwei Lampenschäften 3, in dem sich zwei Elektroden, Anode 5 und Kathode 6, im Abstand von ca. 3 mm gegenüberstehen. An den Lampenschäften 3 sind Sockel 4 befestigt sind, die elektrisch leitend mit den Elektroden verbunden sind. Es handelt sich um eine Gleichstromlampe mit einer Nennleistung von 1000 W. Das Entladungsgefäß 2 ist aus undotiertem Quarzglas gefertigt; es hat in Elektrodenhöhe einen Durchmesser von ca. 30 mm und besitzt eine Wandstärke von ca. 2,8mm. Das Entladungsgefäß hat eine Quecksilberfüllung von ca. 8 mg/cm³ und eine Xenonfüllung (kalt) von ca. 1,7 bar. Das Entladungsgefäß ist auf seiner Außenseite mit einem Mehrschicht-Interferenz-Reflexionsfilter und auf seiner Innenseite mit einer Titandioxid -Beschichtung versehen.

Ein weiteres Ausführungsbeispiel ist eine solche Quecksilberdampf-Kurzbogenlampe mit 3300 W Nennleistung. Das Entladungsgefäß ist hier ebenfalls aus undotiertem Quarzglas gefertigt; es hat in Elektrodenhöhe einen Durchmesser von etwa 70 mm und besitzt eine Wandstärke zwischen 3,5-4,0 mm . Das Entladungsgefäß hat eine Quecksilberfüllung von ca. 3 mg/cm³ und eine Xenonfüllung von ca. 0,8 bar (kalt); es ist ebenfalls auf seiner Außenseite mit einem Mehrschicht-Interferenz-Reflexionsfilter und auf seiner Innenseite mit einer Titandioxid-Beschichtung versehen.

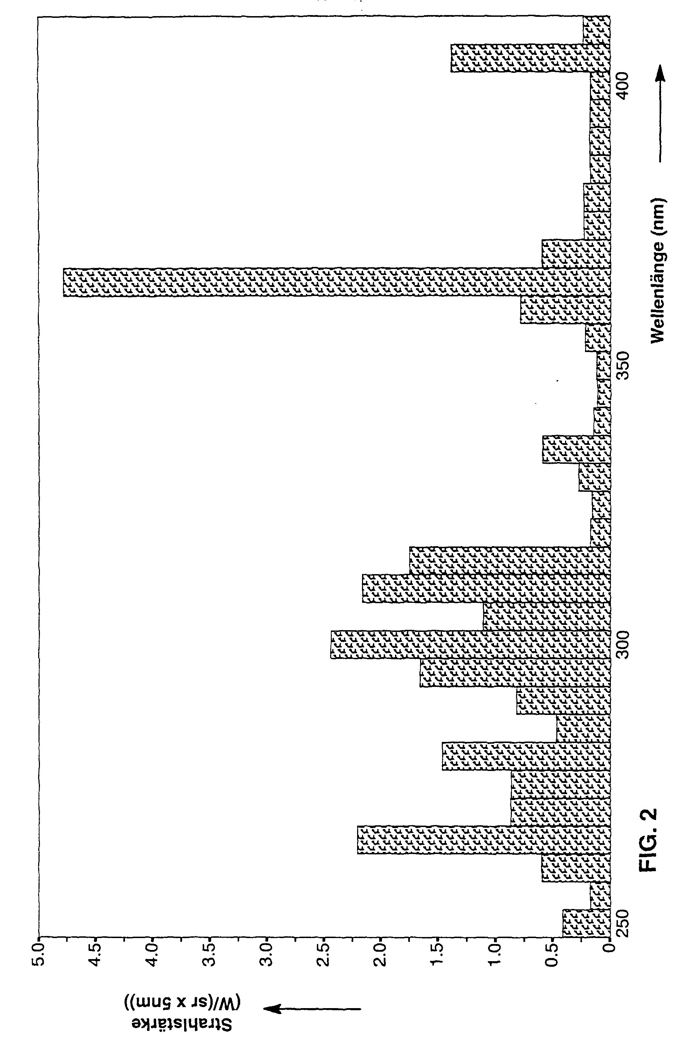

Figur 2 zeigt die spektrale Strahlstärkeverteilung einer Quecksilberdampf-Kurzbogenlampe mit einem Entladungsgefäß aus undotiertem Quarzglas ohne besondere die vom Quecksilberdampfbogen emittierte Strahlung beeinflussende Mittel auf dem Entladungsgefäß im Wellenlängenbereich zwischen 250 und 400 nm. Man erkennt, daß die Lampe in diesem Wellenlängenbereich neben der Strahlung der Nutzwellenlänge 365 nm ein Vielfaches davon an kurzwelligerer Linien- und Kontinuumsstrahlung abgibt.

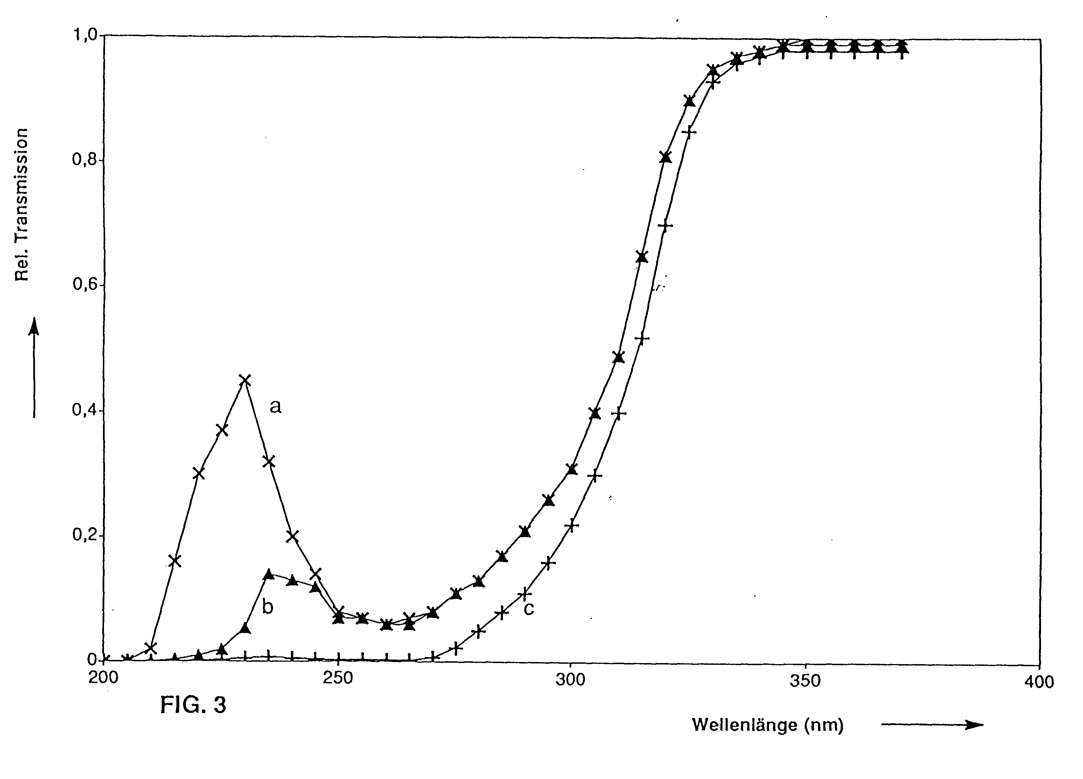

In Figur 3 zeigt Kurve a die spektrale Filterwirkung eines bevorzugt zwischen 240 und 300 nm reflektierenden Mehrschicht-Interferenz-Reflexionsfilters aus 10 Schichten, abwechseln ZrO₂ und SiO₂, auf der Außenseite des Entladungsgefäßes. Aufgetragen ist hier das Verhältnis der Strahlstärken von zwei Quecksilberdampf-Kurzbogenlampen mit 1000 W Nennleistung, einer Lampe mit einem solchen Mehrschicht-Interferenz-Reflektionsfilter und einer Lampe ohne die vom Quecksilberbogen emittierte Strahlung beeinflussende Mittel, als Funktion der Wellenlänge. Strahlung der Nutzwellenlänge 365 nm passiert danach das Filter ungeschwächt, Strahlung kürzerer Wellenlängen wird zunächst zunehmend mit fallender Wellenlänge reflektiert; der 50% Wert der Transmission liegt bei etwa 310 nm. Unterhalb von etwa 250 nm steigt die Transmission infolge fallender Reflexion durch das Mehrschicht-Interferenz-Refiexionsfilter wieder an.

In Figur 3 zeigt Kurve b die spektrale Filterwirkung des bevorzugt im Wellenlängenbereich zwischen 240 und 300 nm reflektierenden Mehrschicht-lnterferenz-Reflexionsfilters (Kurve a aus Figur 3) in Kombination mit der spektralen Filterwirkung einer Titandioxidbeschichtung auf der Innenseite eines Entladungsgefäßes, die zu einer Reduzierung der Transmission unterhalb von etwa 250 nm durch Absorption führt.

In Figur 3 zeigt Kurve c die spektrale Filterwirkung des bevorzugt im Wellenlängenbereich zwischen 240 und 300 nm reflektierenden Mehrschicht-Interferenz-Reflexionsfilters ( Kurve a aus Figur 3) in Kombination mit der spektralen Filterwirkung einer Strahlung unterhalb 240 nm Wellenlänge (50 % Transmission) absorbierenden Titandioxidbeschichtung auf der Innenseite des Entladungsgefäßes und der Filterwirkung eines UV-Strahlung unterhalb von 280 nm (50 % Transmission) absorbierenden Titandioxid/Siliziumdioxid-Mischschicht als letzte hochbrechende Schicht des Mehrschicht-Interferenz-Reflexionsfilters. Man erkennt, daß die Verwendung einer solchen Filterkombination vorteilhafterweise zu einem steileren Abfall der Transmission im Wellenlängenbereich zwischen 280 und 330 nm führt, ohne Strahlung der Nutzwellenlänge 365 nm zu dämpfen.

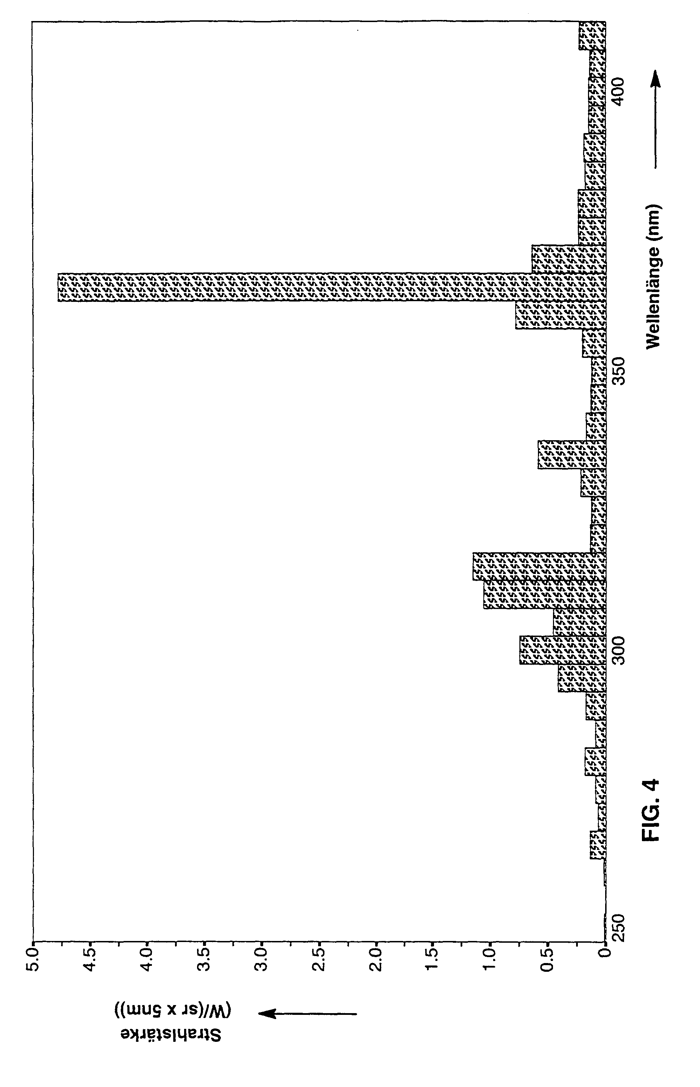

In Figur 4 ist die spektrale Strahlstärkeverteilung einer Quecksilberdampf-Kurzbogenlampe von 1500 W Nennleistung im Wellenlängenbereich zwischen 250 und 400 nm dargestellt, wie sie sich aus der Kombination der Filterwirkungen aus einem bevorzugt Strahlung zwischen 240 und 300 nm reflektierenden Mehrschicht-Interferenz-Reflexionsfilter auf der Außenseite und einer kurzwellige UV-Strahlung unterhalb 250 nm absorbierenden Titandioxid-Beschichtung auf der Innenseite des Entladungsgefäßes ergibt.

Man erkennt im Vergleich zur spektralen Strahlstärkeverteilung einer Quecksilbedampf-Kurzbogenlampe mit einem Entladungsgefäß aus undotiertem Quarzglas und ohne besondere die vom Quecksilberdampfbogen emittierte Strahlung beeinflussende Mittel auf dem Entladungsgefäß (Figur 2) eine deutliche Reduzierung der Strahlstärkewerte unterhalb der Nutzwellenlänge 365 nm, insbesondere im Wellenlängenbereich unterhalb ca. 330nm.

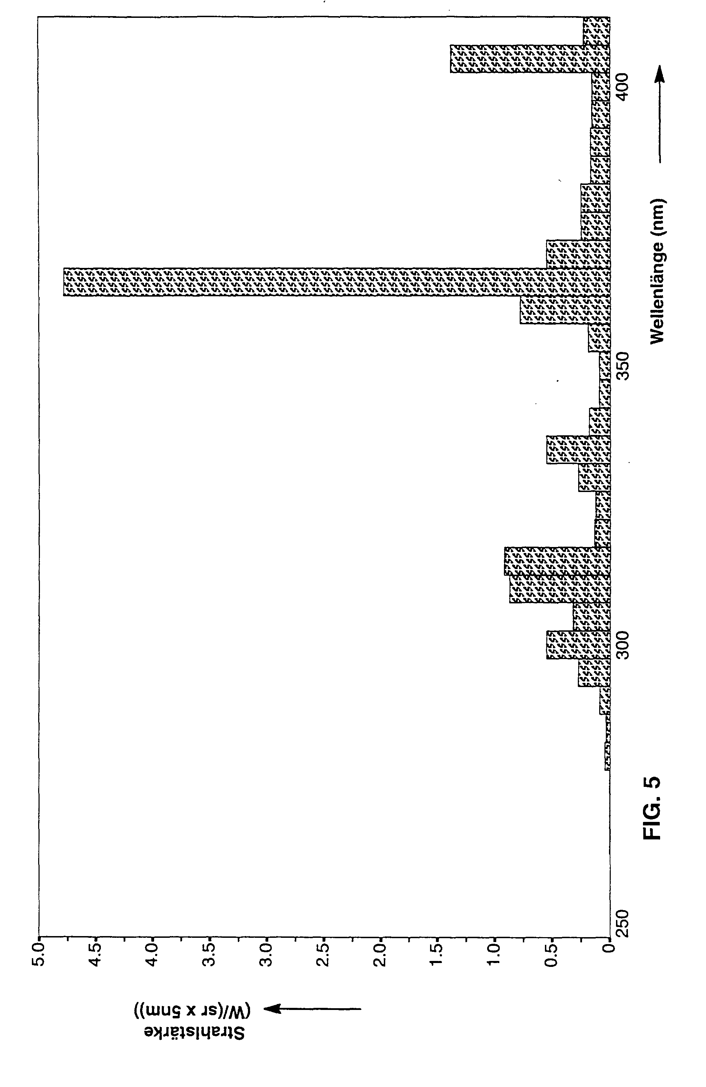

In Figur 5 ist die spektrale Strahlstärkeverteilung einer Quecksilberdampf-Kurzbogenlampe von 1500W Nennleistung im Wellenlängenbereich zwischen 250 und 400 nm dargestellt, wie sie sich aus der Kombination der spektralen Filterwirkungen aus einem bevorzugt Strahlung zwischen 240 und 300 nm reflektierenden Mehrschicht-Interferenz-Reflexionsfilter auf der Außenseite des Entladungsgefäßes, einer darauf aufgebrachten Strahlung unterhalb 330 nm Wellenlänge absorbierenden Titandioxid/Siliziumdioxid-Mischschicht und einer kurzwellige UV-Strahlung unterhalb 240 nm (entsprechend 50% Transmission) absorbierenden Titandioxidbeschichtung auf der Innenseite des Entladungsgefäßes ergibt.

Man erkennt aus dem Vergleich mit Figur 4, daß die Ergänzung der Titandioxidbeschichtung auf der Innenseite des Entladungsgefäßes durch eine unterhalb 330 nm Strahlung absorbierenden Titandioxid/Siliziumdioxid-Mischschicht auf dem Mehrschicht-Interferenz-Reflexionsfilter auf der Außenseite des Entladungsgefäßes zu einer weiteren Schwächung der unerwünschten kurzwelligen UV-Strahlung führt, ohne die Strahlung der Nutzwellenlänge 365 nm merklich zu dämpfen.

Durch den Einsatz der erfindungsgemäßen Lampen wird ein wirtschaftlicherer Betrieb der Belichtungsgeräte bei der Herstellung integrierter Schaltkreise erreicht, da der Aufwand für die Filterung unerwünschter UV-Strahlung und Entlüftung bedeutend reduziert werden kann und es zu deutlich weniger Stillegungszeiten der Geräte durch Wartungs- und Reparaturarbeiten an den optischen Bauteilen kommt.

## Patentansprüche

1. Quecksilberdampf-Kurzbogenlampe mit einem Entladungsgefäß aus Quarzglas, das zwei Elektroden sowie eine Füllung aus Quecksilber und Xenon enthält, wobei das Entladungsgefäß bei Lampenbetrieb eine Oberflächentemperatur von mindestens 400 °C besitzt und mit Mitteln -unter Ausschluß einer Vanadiumdotierung als Mittel - versehen ist, die Strahlung der Quecksilberlinie der Wellenlänge 365 nm praktisch ungeschwächt passieren lassen während Strahlung mit Wellenlängen kleiner 365 nm nahezu vollständig am Verlassen des Entladungsgefäßes gehindert wird, **dadurch gekennzeichnet, daß** die Mittel eine selektiv reflektierende Beschichtung auf der Außenseite des Entladungsgefäßes enthalten, die auch Strahlung größerer Wellenlängen als 365 nm praktisch ungeschwächt passieren läßt.

2. Quecksilberdampf-Kurzbogenlampe nach Anspruch 1, **dadurch gekennzeichnet, dass** das Entladungsgefäß zusätzlich mit einer selektiv absorbierenden Beschichtung auf der Innenseite des Entladungsgefäßes versehen ist.

3. Quecksilberdampf-Kurzbogenlampe nach Anspruch 2, **dadurch gekennzeichnet, dass** die selektiv reflektierende Beschichtung auf der Außenseite des Entladungsgefäßes aus einem Mehrschicht-Interferenz-Reflexionsfilter und die selektiv absorbierende Beschichtung auf der Innenseite des Entladungsgefäßes aus Titandioxid besteht.

4. Quecksilberdampf-Kurzbogenlampe nach Anspruch 3, **dadurch gekennzeichnet, dass** das Mehrschicht-Interferenz-Reflexionsfilter auf der Außenseite des Entladungsgefäßes vorzugsweise selektiv im Wellenlängenbereich zwischen 240 - 300 nm reflektiert und seine Filterkante (entsprechend 50 % Transmission) im Wellenlängenbereich zwischen 290 und 330 nm liegt und die Titandioxid-Beschichtung auf der Innenseite des Entladungsgefäßes vorzugsweise selektiv im Wellenlängenbereich unter 250 nm absorbiert und seine Filterkante (entsprechend 50 % Transmission) bei ca. 240 nm liegt.

5. Quecksilberdampf-Kurzbogenlampe nach Anspruch 1, **dadurch gekennzeichnet, dass** das Entladungsgefäß auf seiner Innenseite mit einer selektiv absorbierenden und auf seiner Außenseite zusätzlich mit einer selektiv absorbierenden Beschichtung versehen ist.

6. Quecksilberdampf-Kurzbogenlampe nach Anspruch 5, **dadurch gekennzeichnet, dass** die selektiv absorbierende Beschichtung auf der Innenseite des Entladungsgefäßes aus einer Titandioxidbeschichtung und die selektiv reflektierende Beschichtung auf der Außenseite des Entladungsgefäßes aus einem Mehrschicht-Interferenz-Reflexionsfilter und die selektiv absorbierende Beschichtung auf der Außenseite des Entladungsgefäßes aus einer darauf aufgebrachten Titandioxid/Siliziumdioxid-Mischschicht besteht.

7. Quecksilberdampf-Kurzbogenlampe nach Anspruch 6, **dadurch gekennzeichnet, dass** die auf der Innenseite des Entladungsgefäßes aufgebrachte Titandioxidbeschichtung vorzugsweise unterhalb 240 nm Wellenlänge (entsprechend 50 % Transmission) absorbiert, das Mehrschicht-Interferenz-Reflexionsfilter auf der Außenseite des Entladungsgefäßes vorzugsweise selektiv Strahlung im Wellenlängenbereich zwischen 240 - 300 nm reflektiert und seine Filterkante (entsprechend 50% Transmission) im Wellenlängenbereich zwischen 290 und 330 nm liegt und die selektiv absorbierende Titandioxid/Siliziumdioxid-Mischschicht vorzugsweise selektiv Strahlung unterhalb 280 nm Wellenlänge (entsprechend 50 % Transmission) absorbiert.

8. Quecksilberdampf-Kurzbogenlampe nach Anspruch 1, **dadurch gekennzeichnet, dass** das Entladungsgefäß aus einem selektiv absorbierenden Quarzglas besteht.

9. Quecksilberdampf-Kurzbogenlampe nach Anspruch 8, **dadurch gekennzeichnet, dass** das Entladungsgefäß aus einem mit Titandioxid dotierten Quarzglas besteht.

10. Quecksilberdampf-Kurzbogenlampe nach den Ansprüchen 4 und 7, **dadurch gekennzeichnet, dass** das Mehrschicht-Interferenz-Reflexionsfilter auf der Außenseite des Entladungsgefäßes aus mindestens 8 Einzelschichten, abwechselnd aus ZrO₂ und aus SiO₂ besteht.

11. Quecksilberdampf-Kurzbogenlampe nach Anspruch 10, **dadurch gekennzeichnet, dass** die Einzelschichten jeweils eine Dicke von ca. 30 nm bis 50 nm aufweisen.

12. Quecksilberdampf-Kurzbogenlampe nach Anspruch 1 **dadurch gekennzeichnet, dass** der Elektrodenabstand zwischen 2 und 9 mm beträgt.

13. Verwendung einer Quecksilberdampf-Kurzbogenlampe nach einem der vorhergehenden Ansprüche für die Belichtung von Photolacken.

## Claims

1. Mercury-vapour short-arc lamp with a discharge vessel made of quartz glass, which contains two electrodes and a filling of mercury and xenon, the discharge vessel having a surface temperature of at least 400°C during operation and being provided with means - with the exclusion of vanadium doping as means - which let the radiation of the mercury line of wavelength 365 nm pass through virtually unattenuated, whereas radiation with wavelengths of less than 365 nm is almost completely prevented from leaving the discharge vessel, **characterised in that** the means contain a selectively reflecting coating on the outside of the discharge vessel, which also lets radiation of wavelengths longer than 365 nm pass through virtually unattenuated.

2. Mercury-vapour short-arc lamp according to Claim 1, **characterised in that** the discharge vessel is additionally provided with a selectively absorbing coating on the inside of the discharge vessel.

3. Mercury-vapour short-arc lamp according to Claim 2, **characterised in that** the selectively reflecting coating on the outside of the discharge vessel consists of a multilayer-interference-reflection filter, and the selectively absorbing coating on the inside of the discharge vessel consists of titanium dioxide.

4. Mercury-vapour short-arc lamp according to Claim 3, **characterised in that** the multilayer-interference-reflection filter on the outside of the discharge vessel preferably selectively reflects in the wavelength range between 240 - 300 nm and its filter edge (corresponding to 50% transmission) lies in the wavelength range between 290 and 330 nm, and the titanium dioxide coating on the inside of the discharge vessel preferably absorbs selectively in the wavelength range below 250 nm and its filter edge (corresponding to 50% transmission) lies at about 240 nm.

5. Mercury-vapour short-arc lamp according to Claim 1, **characterised in that** the discharge vessel is provided on its inside with a selectively absorbing coating and additionally on its outside with a selectively absorbing coating.

6. Mercury-vapour short-arc lamp according to Claim 5, **characterised in that** the selectively absorbing coating on the inside of the discharge vessel consists of a titanium dioxide coating, and the selectively reflecting coating on the outside of the discharge vessel consists of a multilayer-interference-reflection filter, and the selectively absorbing coating on the outside of the discharge vessel consists of a titanium dioxide/silicon dioxide mixed layer applied thereon.

7. Mercury-vapour short-arc lamp according to Claim 6, **characterised in that** the titanium dioxide coating applied on the inside of the discharge vessel preferably absorbs below a wavelength of 240 nm (corresponding to 50% transmission), the multilayer-interference-reflection filter on the outside of the discharge vessel preferably reflects radiation selectively in the wavelength range between 240 - 300 nm and its filter edge (corresponding to 50% transmission) lies in the wavelength range between 290 and 330 nm, and the selectively absorbing titanium dioxide/silicon dioxide mixed layer preferably absorbs radiation selectively below a wavelength of 280 nm (corresponding to 50% transmission).

8. Mercury-vapour short-arc lamp according to Claim 1, **characterised in that** the discharge vessel consists of a selectively absorbing quartz glass.

9. Mercury-vapour short-arc lamp according to Claim 8, **characterised in that** the discharge vessel consists of a quartz glass doped with titanium dioxide.

10. Mercury-vapour short-arc lamp according to Claims 4 and 7, **characterised in that** the multilayer-interference-reflection filter on the outside of the discharge vessel consists of at least 8 individual layers, alternately of ZrO₂ and of SiO₂.

11. Mercury-vapour short-arc lamp according to Claim 10, **characterised in that** the individual layers respectively have a thickness of about 30 nm to 50 nm.

12. Mercury-vapour short-arc lamp according to Claim 1, **characterised in that** the electrode spacing is between 2 and 9 mm.

13. Use of a mercury-vapour short-arc lamp according to one of the preceding claims for the illumination of photoresists.

## Revendications

1. Lampe à arc court à vapeur de mercure, comprenant une enceinte de décharge en verre au quartz qui contient deux électrodes ainsi qu'une atmosphère en mercure et en xénon, l'enceinte de décharge ayant, lorsque la lampe est en fonctionnement, une température de surface d'au moins 400°C et est munie de moyens, à l'exclusion d'un dopage au vanadium comme moyen, pour laisser passer sans affaiblissement pratiquement le rayonnement de la raie du mercure ayant la longueur d'onde de 365 nm, tandis que du rayonnement ayant des longueurs d'onde inférieures à 365 nm est empêché presque complètement de quitter l'enceinte de décharge, **caractérisée en ce que** les moyens comprennent un revêtement réfléchissant sélectivement sur. la face extérieure de l'enceinte de décharge qui laisse passer aussi pratiquement sans affaiblissement du rayonnement de longueur d'onde plus grande que 365 nm.

2. Lampe à arc court à vapeur de mercure suivant la revendication 1, **caractérisée en ce que** l'enceinte de décharge est munie en outre d'un revêtement absorbant sélectivement sur la face intérieure de l'enceinte de décharge.

3. Lampe à arc court à vapeur de mercure suivant la revendication 2, **caractérisée en ce que** le revêtement réfléchissant sélectivement sur la face extérieure de l'enceinte de décharge est constitué d'un filtre de réflexion interférentielle à couches multiples et le revêtement absorbant sélectivement sur la face intérieure de l'enceinte de décharge est en dioxyde de titane.

4. Lampe à arc court à vapeur de mercure suivant la revendication 3, **caractérisée en ce que** le filtre à réflexion interférentielle à plusieurs couches sur la face extérieure de l'enceinte de décharge réfléchit, de préférence sélectivement, dans le domaine de longueur d'onde compris entre 240 et 300 nm et son bord de filtrage (correspondant à une transmission de 50%) se trouve dans le domaine de longueur d'onde compris entre 290 et 330 nm et le revêtement en dioxyde de titane sur la face intérieure de l'enceinte de décharge absorbe de préférence sélectivement dans le domaine de longueur d'onde inférieur à 250 nm et son bord de filtrage (correspondant à une transmission de 50%) est à environ 240 nm.

5. Lampe à arc court à vapeur de mercure suivant la revendication 1, **caractérisée en ce que** l'enceinte de décharge est munie sur sa face intérieure d'un revêtement absorbant sélectivement et sur sa face extérieure, en outre, d'un revêtement absorbant sélectivement.

6. Lampe à arc court à vapeur de mercure suivant la revendication 5, **caractérisée en ce que** le revêtement absorbant sélectivement sur la face intérieure de l'enceinte de décharge est un revêtement en dioxyde de titane et le revêtement réfléchissant sélectivement sur sa face extérieure de l'enceinte de décharge est constitué d'un filtre de réflexion interférentielle à couches multiples et le revêtement absorbant sélectivement sur la face extérieure de l'enceinte de décharge est constitué d'une couche mixte qui y est déposée en dioxyde de titane et en dioxyde de silicium.

7. Lampe à arc court à vapeur de mercure suivant la revendication 6, **caractérisée en ce que** le revêtement en dioxyde de titane déposé sur la face intérieure de l'enceinte de décharge absorbe de préférence des longueurs d'onde inférieures à 240 nm (correspondant à une transmission de 50%), le filtre de réflexion interférentielle à couches multiples sur la face extérieure de l'enceinte de décharge réfléchit de préférence sélectivement du rayonnement dans le domaine de longueur d'onde compris entre 240 et 300 nm et son bord de filtrage (correspondant à une transmission de 50%) est dans le domaine de longueur d'onde compris entre 290 et 330 nm et la couche mixte absorbant sélectivement en dioxyde de titane et en dioxyde de silicium absorbe de préférence sélectivement du rayonnement de longueur d'onde inférieur à 280 nm (correspondant à une transmission de 50%).

8. Lampe à arc court à vapeur de mercure suivant la revendication 1, **caractérisée en ce que** l'enceinte de décharge est en un verre au quartz absorbant sélectivement.

9. Lampe à arc court à vapeur de mercure suivant la revendication 8, **caractérisée en ce que** l'enceinte de décharge est en un verre au quartz dopé par du dioxyde de titane.

10. Lampe à arc court à vapeur de mercure suivant les revendications 4 et 7, **caractérisée en ce que** le filtre de réflexion interférentielle à couches multiples sur la face extérieure de l'enceinte de décharge est constitué d'au moins huit couches individuelles en alternance en ZrO₂ et en SiO₂.

11. Lampe à arc court à vapeur de mercure suivant la revendication 10, **caractérisée en ce que** les couches individuelles ont respectivement une épaisseur d'environ 30 nm à 50 nm.

12. Lampe à arc court à vapeur de mercure suivant la revendication 1, **caractérisée en ce que** la distance entre les électrodes est comprise entre 2 et 9 mm.

13. Utilisation d'une lampe à arc court à vapeur de mercure suivant l'une des revendications précédente pour l'exposition de vernis photosensibles.
